# FASCICULE DE BREVET EUROPEEN

(11) **EP 0 641 014 B1**
(45) Date de publication et mention de la délivrance du brevet: **19.03.1997**
(21) Numéro de dépôt: 94401885.2
(22) Date de dépôt: 23.08.1994
(51) Int. Cl.: H01J 37/32, H05H 1/46

(54) **Réacteur à plasma pour un procédé de dépôt ou de gravure**
Plasma Reaktor für Abscheidung- oder Ätz-Prozess
Plasma reactor for deposition or etching process

(30) Priorité: 27.08.1993 FR 9310301
(43) Date de publication de la demande: 01.03.1995
(73) Titulaire: ALCATEL CIT, 75008 Paris (FR)
(72) Inventeur: Pearson, David, F-74000 Annecy (FR)
(74) Mandataire: Gosse, Michel

(56) Documents cités:
- EP-A- 0 403 418
- EP-A- 0 489 407

## Description

La présente invention concerne un réacteur à plasma pour un procédé de dépôt ou de gravure.

On sait que dans de telles machines, celles du type à excitateur inductif de plasma, permettent d'obtenir une densité ionique beaucoup plus élevée, de l'ordre de 100 fois, que celles du type à excitation capacitive.

On connaît par exemple par le document W0 86/06923 une machine du type à excitateur inductif dans laquelle l'antenne excitatrice couple l'énergie radiofréquence à un volume de forme cylindrique, et sur une longueur de plus de 200mm.

Cette disposition, pour la source excitative, assure une densité ionique élevée à basse pression, tandis que le profil radial de cette densité, dans la source ou près de la zone de formation du plasma, n'est pas uniforme.

Afin de produire un profil de densité ionique uniforme au niveau du substrat à traiter, ce dernier est placé éloigné de la source dans une région de plasma de diffusion. Ce dernier a une densité ionique réduite, voire fortement diminuée pour les gaz électronégatifs, tels que SF₆, C₂F₆ ou Cl₂ pour lesquels la densité chute rapidement en fonction de la pression (au-delà de quelques 10⁻³ mbar) et de la séparation source-substrat. Or, de tels gaz sont typiquement utilisés à des pressions supérieures à 10⁻² mbar en gravure profonde et rapide ou en dépôt PECVD (Plasma Enhance Chemical Vapor Deposition).

On connaît aussi par le document EP 0 413 282 une machine du type à excitateur inductif dans laquelle l'antenne excitatrice est plane et a la forme d'un serpentin enroulé en spirale.

Cette disposition, pour la source excitative, assure une bonne uniformité ionique. Par rapport aux autres sources inductives connues, elle assure une meilleure uniformité à haute pression (supérieure à 10⁻² mbar). Elle assure également, vis-à-vis des autres sources inductives connues, une meilleure densité ionique lors de l'utilisation de gaz électronégatifs, tels que SF₆, C₂F₆, Cl₂ cités ci-dessus.

Cependant, avec une telle antenne comme source excitative de plasma, le champ électromagnétique est relativement élevé à une distance éloignée de l'antenne procurant une forte énergie aux particules ionisées, ce qui, dans le cas de gravure, peut endommager le substrat à graver.

Le document EP 0 403 418 décrit également un appareil de dépôt et de gravure sous plasma à haute densité dans lequel l'antenne excitatrice est constituée de deux boucles circulaires situées l'une au-dessus de l'autre et parallèles au substrat à traiter.

Les deux boucles sont réunies par des conducteurs et l'ensemble est alimenté par un générateur de puissance radio-fréquence. L'antenne est disposée autour d'un tube diélectrique en quartz.

Cependant, on a constaté, avec une telle disposition, une forte érosion du tube au droit des conducteurs reliant les deux boucles.

La présente invention a pour but de pallier les inconvénients des machines existantes citées ci-dessus et a pour objet un réacteur à plasma pour un procédé de dépôt ou de gravure comportant une enceinte à vide destinée à recevoir un substrat à traiter, et comportant des moyens pour l'introduction d'un gaz à ioniser, ladite enceinte étant fermée par un conteneur en matériau diélectrique, le plasma étant produit dans ledit conteneur et étant excité par une antenne entourant ledit conteneur et alimentée par un générateur de puissance radio-fréquence, caractérisé en ce que ladite antenne est composée d'un conducteur électrique constituant une unique boucle circulaire dont deux points diamétralement opposés sont reliés à des conducteurs d'alimentation reliés au générateur de puissance radio-fréquence.

Selon une autre caractéristique, ledit générateur de puissance radio-fréquence alimente ladite antenne par l'intermédiaire d'un circuit d'adaptation comportant un premier condensateur variable relié en série à un second condensateur variable monté en parallèle aux bornes de ladite antenne.

D'autres caractéristiques de la présente invention ressortiront de la description d'un exemple de mise en oeuvre de l'invention faite ci-après en regard du dessin annexé dans lequel :

La figure 1 représente schématiquement un réacteur à plasma selon l'invention.

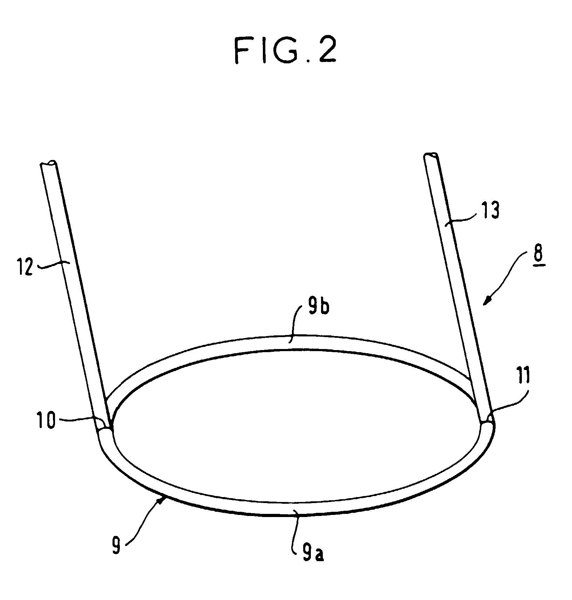

La figure 2 montre, en vue agrandie, l'antenne excitatrice selon l'invention.

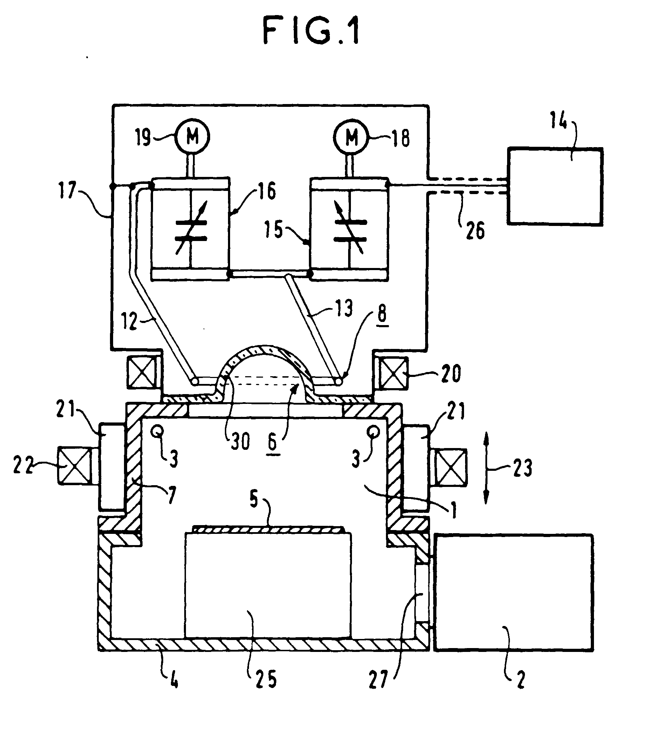

En se référant à la figure 1, le réacteur à plasma comprend essentiellement une enceinte à vide 1 pompée par un groupe de pompage 2. Des trous 3 permettent l'introduction d'un gaz de traitement à ioniser par exemple du SF₆, C₂F₆, Cl₂, etc....

L'enceinte est fermée à sa partie inférieure par un compartiment inférieur 4 comportant un orifice 27 pour la liaison avec ledit groupe de pompage 2. Ce compartiment inférieur 4 est équipé d'un porte-substrat 25 qui, selon le procédé de traitement envisagé (dépôt ou gravure), peut permettre la polarisation, le chauffage ou le refroidissement du substrat 5 ainsi que son positionnement vertical.

A sa partie supérieure, l'enceinte est fermée par un conteneur 6 en forme de "chapeau melon" en quartz ou en un autre matériau diélectrique compatible avec le traitement. La paroi latérale 7 de l'enceinte 1 est en matériau conducteur amagnétique.

La source d'excitation, pour générer dans l'enceinte 1 le plasma, est constituée par une antenne 8 entourant la partie hémisphérique 30 du conteneur du plasma 6.

Cette antenne 8 est composée d'un conducteur électrique 9 constituant une unique boucle circulaire dont deux points diamétralement opposés 10 et 11 sont reliés à des conducteurs d'alimentation 12 et 13 qui alimentent ainsi en parallèle les deux demi-parties 9a et 9b de la boucle 9.

Les conducteurs d'alimentation 12 et 13 sont reliés à un générateur de puissance radio-fréquence 14 à 13,56 MHz par l'intermédiaire d'un circuit d'adaptation comportant un premier condensateur variable 15 relié directement au générateur 14 et relié en série à une borne d'un second condensateur variable 16, monté en parallèle aux bornes de l'antenne 8, et dont la deuxième borne est reliée au retour 26 du générateur radio-fréquence 14 qui est électriquement relié au châssis 17 formant masse. Les condensateurs variables 15 et 16 sont réglés par des moteurs 18 et 19 commandés par un circuit d'adaptation automatique ou manuelle. L'antenne 8 est avantageusement refroidie à l'eau.

Autour de l'antenne 8 est placée une première bobine électrique 20 de façon à produire un champ magnétique perpendiculaire au plan de l'antenne 8.

Tout autour de l'enceinte 1 sont en outre disposés des aimants permanents 21 polarisés radialement et successivement en sens inverse les uns des autres de façon à former un champ de confinement "multi-polaire" pour le plasma.

Enfin, une deuxième bobine électrique 22 est en outre disposée autour de l'enceinte 1 de façon à produire un champ magnétique perpendiculaire à un plan situé entre l'antenne 8 et le substrat 5 et parallèle à ce dernier. Le positionnement de cette bobine 22 est réglable comme le figure la flèche à double sens 23. Les bobines 20 et 22, alimentées en courant continu, servent à optimiser l'intensité et l'uniformité du plasma et du procédé au niveau du substrat 5.

Pour la source de l'invention (l'antenne 8), le volume du conteneur 6 dans lequel le plasma est produit étant faible par rapport à la source de forme cylindrique décrite dans le premier document antérieur cité en introduction, le couplage de la puissance radiofréquence au plasma est plus efficace et, en conséquence, le rendement en flux total ionique par Watt est plus élevé relativement à ces sources.

Grâce aux deux demi-parties 9a et 9b en demi-cercle de l'antenne 8 alimentées en parallèle, l'inductance de l'antenne est réduite de façon significative par rapport aux antennes des documents antérieurs cités en introduction. Il en résulte, d'une part, un champ électrique induit dans le plasma plus faible, minimisant ainsi l'énergie des particules chargés au niveau du substrat 5, et d'autre part, une meilleure efficacité dans le transfert de la puissance du générateur radiofréquence au plasma.

La présence du champ magnétique statique produit par les bobines 20, 22 permet de générer des ondes résonnantes stationnaires dans le plasma qui augmentent le rendement et l'efficacité de couplage de l'énergie radio-fréquence aux électrons du plasma. L'énergie des électrons, qui seront thermalisés, est transférée au plasma par des collisions d'où la forte densité ionique.

Le plasma produit par le réacteur à plasma de l'invention peut être utilisé pour les procédés de gravure ioniques réactive et sélective, de nettoyage par pulvérisation ou de dépôt PECVD (Plasma enhance chemical vapour deposition) de couches minces sur le substrat.

## Revendications

1. Réacteur à plasma pour un procédé de dépôt ou de gravure comportant une enceinte à vide (1) destinée à recevoir un substrat (5) à traiter, et comportant des moyens (3) pour l'introduction d'un gaz à ioniser, ladite enceinte étant fermée par un conteneur (6) en matériau diélectrique, le plasma étant produit dans ledit conteneur et étant excité par une antenne (8) entourant ledit conteneur (6) et alimentée par un générateur de puissance radio-fréquence (14), caractérisé en ce que ladite antenne est composée d'un conducteur (9) électrique constituant une unique boucle circulaire dont deux points diamétralement opposés (10, 11) sont reliés à des conducteurs d'alimentation (12, 13) reliés au générateur de puissance radio-fréquence (14).

2. Réacteur à plasma selon la revendication 1, caractérisé en ce que ledit générateur de puissance radio-fréquence (14) alimente ladite antenne (8) par l'intermédiaire d'un circuit d'adaptation comportant un premier condensateur variable (15) relié en série à un second condensateur variable (16) monté en parallèle aux bornes de ladite antenne (8).

3. Réacteur à plasma selon l'une des revendications 1 ou 2, caractérisé en ce qu'une pluralité d'aimants permanents (21) est disposée autour de ladite enceinte (1) à vide, lesdits aimants (21) étant polarisés radialement et successivement en sens inverse les uns des autres.

4. Réacteur à plasma selon l'une des revendications précédentes, caractérisé en ce qu'une bobine électrique (22), alimentée en courant continu, est disposée autour de ladite enceinte (1), l'axe de ladite bobine étant perpendiculaire au plan de ladite antenne (8), ladite bobine étant réglable en position le long dudit axe.

5. Réacteur à plasma selon l'une des revendications précédentes, caractérisé en ce qu'une bobine électrique (20), alimentée en courant continu, est disposée autour de ladite antenne (8), l'axe de ladite bobine (20) étant perpendiculaire au plan de l'antenne (8).

## Patentansprüche

1. Plasmareaktor für ein Beschichtungs- oder Ätzverfahren, mit einem Vakuumgefäß (1), das ein zu behandelndes Substrat (5) aufnimmt und Mittel (3) zur Einspeisung eines zu ionisierenden Gases besitzt, wobei das Gefäß von einem Behälter (6) aus dielektrischem Material verschlossen wird und das Plasma in diesem Behälter aufgrund einer Anregung durch eine den Behälter (6) umgebende und von einem Hochfrequenz-Leistungsgenerator (14) gespeiste Antenne (8) angeregt wird, dadurch gekennzeichnet, daß die Antenne von einem elektrischen Leiter (9) gebildet wird, der eine einzige kreisförmige Schleife bildet, die an zwei diametral gegenüberliegenden Stellen (10, 11) mit Speiseleitern (12, 13) verbunden ist, die an den Hochfrequenz-Leistungsgenerator (14) angeschlossen sind.

2. Plasmareaktor nach Anspruch 1, dadurch gekennzeichnet, daß der Hochfrequenz-Leistungsgenerator (14) die Antenne (8) über eine Anpassungsschaltung speist, die einen ersten variablen Kondensator (15) in Reihe mit einem zweiten variablen Kondensator (16) enthält, zu dem die Klemmen der Antenne (8) parallelgeschaltet sind.

3. Plasmareaktor nach einem der Ansprüche 1 oder 2, dadurch gekennzeichnet, daß mehrere Permanentmagneten (21) um das Vakuumgefäß (1) herum angeordnet sind und radial abwechselnd in Gegenrichtung polarisiert sind.

4. Plasmareaktor nach einem der vorhergehenden Ansprüche, dadurch gekennzeichnet, daß eine elektrische Spule (22), die mit Gleichstrom gespeist wird, um das Gefäß herum angeordnet ist, wobei die Achse der Spule senkrecht zur Ebene der Antenne (8) verläuft und die Lage der Spule entlang der Achse einstellbar ist.

5. Plasmareaktor nach einem der vorhergehenden Ansprüche, dadurch gekennzeichnet, daß eine elektrische Spule (20), die mit Gleichstrom gespeist wird, um die Antenne (8) herum angeordnet ist, wobei die Achse der Spule (20) senkrecht zur Ebene der Antenne (8) verläuft.

## Claims

1. A plasma reactor for performing an etching or deposition method, said reactor including a vacuum enclosure (1) designed to receive a substrate (5) to be treated, and including means (3) for inserting a gas to be ionized, said enclosure being closed by a container (6) made of dielectric material, the plasma being produced in said container and being excited by an antenna (8) surrounding said container (6) and fed by a radio-frequency power generator (14), said plasma reactor being characterized in that said antenna is composed of an electrical conductor (9) that constitutes a single circular loop having two diametrically-opposite points (10, 11) connected to feed conductors (12, 13) connected to the radio-frequency power generator (14).

2. A plasma reactor according to claim 1, characterized in that said radio-frequency power generator (14) feeds said antenna (8) via an impedance-matching circuit comprising a first variable capacitor (15) connected in series with a second variable capacitor (16) connected in parallel across the terminals of said antenna (8).

3. A plasma reactor according to claim 1 or 2, characterized in that a plurality of permanent magnets (21) are disposed around said vacuum enclosure (1), said magnets (21) being polarized radially and successively in opposite directions from one another.

4. A plasma reactor according to any preceding claim, characterized in that a DC-powered electrical coil (22) is disposed around said enclosure (1), the axis of said coil being perpendicular to the plane of said antenna (8), the position of said coil being adjustable along said axis.

5. A plasma reactor according to any preceding claim, characterized in that a DC-powered electrical coil (20) is disposed around said antenna (8), the axis of said coil (20) being perpendicular to the plane of the antenna (8).
